# EUROPÄISCHE PATENTSCHRIFT

(11) **EP 2 880 662 B1**
(45) Veröffentlichungstag und Bekanntmachung des Hinweises auf die Patenterteilung: **28.06.2017**
(21) Anmeldenummer: 13744488.1
(22) Anmeldetag: 26.07.2013
(51) Int. Cl.: H01B 1/16, C04B 41/88, H05K 1/11, H05K 3/00, C04B 111/00, C04B 41/00, C04B 41/51

(54) **VERFAHREN ZUR METALLISIERUNG VON DURCHKONTAKTIERUNGEN**
METHOD FOR METALIZING PLATED-THROUGH HOLES
PROCÉDÉ DE MÉTALLISATION DE TROUS DE CONNEXION

(30) Priorität: 30.07.2012 DE 102012213346
(43) Veröffentlichungstag der Anmeldung: 10.06.2015
(73) Patentinhaber: CeramTec GmbH, 73207 Plochingen (DE)
(72) Erfinder: THIMM, Alfred, 95632 Wunsiedel (DE); HERRMANN, Klaus, 95707 Thiersheim (DE)
(74) Vertreter: Uppena, Franz
(86) Internationale Anmeldenummer: PCT/EP2013/065815
(87) Internationale Veröffentlichungsnummer: WO 2014/019956

(56) Entgegenhaltungen:
- US-A- 4 020 206
- US-A1- 2004 070 915

## Beschreibung

Die Erfindung betrifft ein Verfahren zur Herstellung von Durchkontaktierungen in Leiterplatten und solcherart hergestellte Leiterplatten.

Keramische Leiterplatten müssen oft von beiden Seiten elektrisch kontaktierbar sein und eine Durchkontaktierung durch die Leiterplatte ermöglichen. Dies erfolgt im Allgemeinen durch in der Leiterplatte vorgesehene Löcher, die mit elektrisch leitendem Material gefüllt sind. Solche Durchkontaktierungen oder Vias weisen üblicherweise Durchmesser von etwa 100 bis 300 µm auf.

Als elektrisch leitendes Material sind heute vergleichsweise teure Silber- oder andere Edelmetallpasten üblich, die aus einem oder mehreren Metallpulvern, gegebenenfalls einem Haftglasanteil von 1-10 Gew.-%, beispielsweise PbO, B₂O₃, Bi₂O₃ oder SiO₂, und einer hochsiedenden Organik, umfassend Binder wie Ethylcellulose oder Polyvinylbutyral, und Lösungsmitteln wie Terpineol oder Texanol, zusammengesetzt sind. Wenn das Substratmaterial für die Leiterplatten aus AIN besteht, können ZnO, SiO₂, CaO, TiO₂ und B₂O₃ als Haftgläser verwendet werden.

US2004/070915A1 offenbart ein Verfahren zur Herstellung von elektrischen Durchkontaktierungen in einer Leiterplatte, umfassend das Mischen einer Paste, Einbringen der Paste in Löcher einer Leiterplatte und Aushärten der Paste unter Wärmeeinwirkung, wobei die Paste zumindest ein elektrisch leitfähiges Material und Füllstoffe umfasst, dadurch gekennzeichnet, dass die Füllstoffe beim Aushärten eine Volumenzunahme erfahren, so dass ein Volumenschrumpf des elektrisch leitfähigen Materials durch das Aushärten bei Wärmeeinwirkung ausgeglichen wird.

US 4 020 206 A offenbart leitfähige Pasten mit einer Schrumpfung von weniger als 2 bis 4%.

Zunehmend finden als elektrisch leitende Materialien auch Kupfermetallisierungen Verwendung, wobei zum Verfüllen der Vias oft Pasten gefüllt mit Kupferpartikeln mit Durchmessern von etwa 1 bis 10 µm und einem Haftglasanteil verwendet werden. Anschließend wird das Material bei 650 bis 1200°C in einer Stickstoffatmosphäre mit einem geringen Anteil Sauerstoff (< 1-100 ppm) eingebrannt. Bei der Verwendung von Kupferpasten ergibt sich das Problem, dass sie beim Einbrennen stark schrumpfen, reißen und/oder aus den Vias wieder heraus fallen - wenn sie nur aus den oben üblichen genannten Substanzen bestehen. Es können dann in der Metallisierung oder im Anbindungsbereich der Flächenmetallisierung große Hohlräume und/oder Risse entstehen. Im schlimmsten Fall können die Vias zu einem Stift versintern und aus dem Loch heraus fallen. In den Fällen, in denen Risse oder Hohlräume entstehen, weisen die Durchkontaktierungen einen erhöhten elektrischen Widerstand auf und sind auch nicht hermetisch dicht.

Die Dichtigkeit gegenüber der umgebenden Atmosphäre ist insbesondere wichtig, wenn sauerstoffempfindliche Teile, beispielsweise Schaltungen (Si), LEDs oder OLEDs verbaut werden sollen. Nach oben sind diese Bauteile meist durch aufgelötete oder geklebte Deckel, Linsen oder Ähnliches geschützt. Aber auch von unten darf keine Luft oder Feuchtigkeit einziehen können, was unter anderem durch hermetisch dichte Metallisierungen der Durchkontaktierungen realisiert wird.

Der Schrumpfung des elektrisch leitfähigen Materials beim Sintern versucht man durch die Zugabe von Haftglas entgegen zu wirken. Trotz des in der Paste enthaltenen Haftglases sind die negativen Auswirkungen der Schrumpfung häufig jedoch zumindest nicht ausreichend zu vermeiden.

Besonders problematisch ist diese Erscheinung bei AIN-Keramiken, weil nur wenige Stoffe das AIN in der Hitze unzersetzt lassen. AIN ist nur metastabil und zersetzt sich unter Bildung der energieärmsten Aluminiumverbindung Al₂O₃ unter bestimmten Bedingungen. Einige Oxide wie insbesondere das gern verwendete Bi₂O₃ oder das früher übliche PbO greifen AIN heftig an, unter Zersetzung zu Aluminiumoxid, Blei und Stickstoff nach folgender Reaktionsgleichung:

2AIN+3PbO→Al₂O₃+3Pb+N₂.

Andere Oxide wie ZnO zersetzen AIN nur langsam und sind daher als Bindemittel der Metallisierung zur Keramik besser geeignet. Außerdem ist bei AIN auf einen geringen TCE (thermischer Ausdehnungskoeffizient) zu achten, damit die Verbindung nicht reißt.

Klassische Zuschlagstoffe wie Bleioxid oder Wismutoxid sind darüber hinaus aus Umweltschutzgründen zu vermeiden oder reagieren zu stark mit AIN. Der infolge der Zersetzungsreaktion aus dem AIN entstehende Stickstoff, siehe oben, macht die Metallisierung porös und treibt sie auf.

Aufgabe der Erfindung ist daher ein Verfahren zur Verfügung zu stellen mit dem Durchkontaktierungen, die sicher in den Löchern der Leiterplatten halten und gute

Eigenschaften in Bezug auf die Stromleitung aufweisen, herstellbar sind. Das bereitgestellte Verfahren sollte sich soweit wie möglich an übliche Verfahren anlehnen, um kostspielige Umrüstungen zu vermeiden. Darüber hinaus sollen Materialien bereitgestellt werden, die die Herstellung von Durchkontaktierungen hoher Qualität bei geringem Aufwand ermöglichen.

Die Aufgabe wird durch ein Verfahren gemäß Anspruch 1 und eine Metallisierung gemäß Anspruch 12 gelöst. Die Unteransprüche definieren bevorzugte Ausführungsformen der Erfindung.

Demgemäß umfasst ein Verfahren zur Herstellung von elektrischen Durchkontaktierungen, das die Schrumpfung der Pasten beim Einbrennen vermeidet oder im Wesentlichen jedenfalls stark vermindert, folgende Schritte: Mischen einer Paste, Einbringen der Paste in Löcher einer Leiterplatte und Aushärten der Paste unter Wärmeeinwirkung. Die Paste umfasst dabei zumindest ein elektrisch leitfähiges Material und Füllstoffe, wobei die Füllstoffe beim Aushärten eine Volumenzunahme erfahren, so dass ein Volumenschrumpf des elektrisch leitfähigen Materials durch das Aushärten bei Wärmeeinwirkung ausgeglichen wird.

Die Erfindung ist grundsätzlich für Leiterplatten aller Materialien geeignet, besonders bevorzugt werden jedoch Leiterplatten aus Keramik, insbesondere aus einer Keramik auf Basis von AIN oder Al₂O₃.

Als elektrisch leitfähiges Material können bevorzugt Kupferpartikel, insbesondere mit einer mittleren Korngröße d50 zwischen 1 und 10 µm verwendet werden. Andere leitfähige Substanzen, insbesondere für diese Zwecke übliche Metalle oder Metalllegierungen können jedoch auch Verwendung finden.

Die erfindungsgemäßen Füllstoffe können beispielsweise nitridbildende Substanzen sein, die der Paste zugeben werden. Beim Einbrennen unter einer Stickstoffatmosphäre nitrieren diese Substanzen oder Füllstoffe und erfahren durch die Nitrierung eine Volumenvergrößerung. Diese Volumenvergrößerung gleicht Volumenverminderungen des leitfähigen Materials, z.B. durch Versintern der Partikel, zumindest weitgehend wieder aus.

Solche nitridbildenden Substanzen können insbesondere Aluminium, Titan, Zirkonium und/oder Mischungen dieser Substanzen sein. Bevorzugt werden diese Materialien in Mengen von 1 bis 10 Gew.-%, bevorzugt 2 bis 5 Gew.-% der Mischung zur Herstellung der Pasten zugegeben.

Weitere Substanzen, die bei der Aushärtung oder Umwandlung unter Wärmeeinwirkung eine Volumenzunahme erfahren, können blähende Nichtmetalle sein, insbesondere Tone. Gemäß einer bevorzugten Ausführungsform der Erfindung können die blähenden Nichtmetalle zwischen 1 und 10 Gew.-%, bevorzugt zwischen 2 und 5 Gew.-% der Mischung zur Herstellung der Pasten ausmachen.

Blähende Tone umfassen beispielsweise Bentonit oder Montmorillonit, die darüber hinaus vorteilhaft eine hohe Affinität zu AIN- oder Al₂O₃-Keramiken aufweisen. Eine Affinität der Füllstoffe im Allgemeinen zur verwendeten Keramik ist überhaupt wünschenswert, um einen sicheren Halt der Metallisierung bzw. des elektrisch leitfähigen Materials in den Löchern der Leiterplatte zu gewährleisten. Bezüglich der Erfindung wird Affinität wie folgt verstanden: Die Fähigkeit des elektrisch leitfähigen Materials mit dem Material der Keramik eine feste Verbindung einzugehen, die auch bei mechanischer Belastung nicht sofort gelöst wird. Unter dem Begriff "Verbindung" wird nicht nur eine chemische Verbindung verstanden, sondern allgemein das haltbare Zusammenfügen von Stoffen.

Jede der genannten Substanzen oder Füllstoffe kann alleine oder in Verbindung mit anderen den Volumenschrumpf des elektrischen leitfähigen Materials ausgleichen.

Die genannten Metalle, die als Füllstoffe zugegeben werden, zeigen bei der Nitridbildung ebenso wie der Ton eine Volumenvergrößerung, welche den Schrumpf des elektrisch leitfähigen Materials, insbesondere des Kupfers, ausgleicht.

Die Haftung zwischen der Metallisierung und dem Leiterplattensubstrat kann gemäß einer bevorzugten Weiterbildung der Erfindung durch nur langsam mit dem Substratmaterial reagierende Oxide verbessert werden. Besteht das Substratmaterial beispielsweise aus AIN können als nur langsam mit dem Substratmaterial reagierende Oxide ZnO, SiO₂, CaO, TiO₂ und B₂O₃ eingesetzt werden. Darüber hinaus kann als haftvermittelnde Substanz auch CuCl zugesetzt werden, das unter Wärmeeinwirkung elementares Kupfer bildet.

Darüber hinaus können zusätzlich noch Haftgläser zugegeben werden. Bei einem Al₂O₃-Keramiksubstrat werden bevorzugt Bi₂O₃-haltige Haftgläser verwendet. Diese Gläser weisen einen thermischen Ausdehnungskoeffizienten (TCE) auf, der Risse durch Spannungen beim Aushärten der Paste verhindert. Anstelle oder zusätzlich können auch ZnO-haltige Haftgläser zugegeben werden.

Bei AIN-Keramiken als Leiterplattensubstrat werden bevorzugt ZnO-haltige Haftgläser zugegeben. Bi₂O₃-haltige Haftgläser wie sie bei Al₂O₃-haltigen Keramiksubstraten bevorzugt verwendet werden, eignen sich dagegen nicht besonders für AIN-Keramiken, da sich diese Gläser schlecht mit AIN verbinden und ihre Zugspannung zu Rissen in den AIN-Keramiken führen kann.

Eine generelle Formulierung für eine Metallisierung kann wie folgt aussehen:

| | |
|---|---|
| Öl, thixotrop | 5 - 20 Gew.-%, bevorzugt 8-12 Gew.-%, |
| Öl, Siebdruckmedium | 5-20 Gew.-%, bevorzugt 8-12 Gew.-%, |
| elektrisch leitf. Material | 10 - 89 Gew.-%, bevorzugt 50 - 80 Gew.-% |
| Füllstoffe, gesamt | 2-25 Gew.-%, bevorzugt 4-15 Gew.-%, davon |
| nitridbildende Substanzen, jeweils | 1-10 Gew.-%, bevorzugt 2-5 Gew.-%, |
| blähende Nichtmetalle, jeweils | 1-10 Gew.-%, bevorzugt 2-5 Gew.-%, |
| haftvermittelnde Substanz, jeweils | 0,1 - 5 Gew.-%. |

Die Erfindung wird im Folgenden anhand von Beispielen näher erläutert. Die Beispiele dienen lediglich der Erläuterung der Erfindung und sind in keiner Weise als die Erfindung beschränkend zu betrachten.

Es wird eine Paste zur Metallisierung von Durchkontaktierungen in einem AIN- oder einem Al₂O₃-Keramiksubstrat nach folgender Rezeptur hergestellt:

| | | |
|---|---|---|
| Öl THIXOTROP | | 10 Gew.-% |
| Öl Siebdruckmedium | | 10 Gew.-% |
| Kupferpulver, d50 =10 µm | 1-90%, bevorzugt | 50 Gew.-% |
| Kupferpulver, d50 = 1 µm | 0-50%, bevorzugt | 12 Gew.-% |
| Aluminiumpulver, d50 = 8 µm | 0,1-10%, bevorzugt | 5 Gew.-% |
| Bentonit, d50 = 12 µm | 0,0-10%, bevorzugt | 5 Gew.-% |
| Zinkoxid, d50 = 5 µm | 0,1 - 5%, bevorzugt | 2 Gew.-% |
| Quarzmehl, d50 = 6 µm | 0,1 - 5%, bevorzugt | 1,5 Gew.-% |
| Boroxid, d50 = 10 µm | 0,1 - 5%, bevorzugt | 1,5 Gew.-% |
| Kupfer(I)-chlorid, d50 = 5 µm | 0,1 - 5%, bevorzugt | 3 Gew.-% |

Die festen abgewogenen Bestandteile der Paste werden mit einem Spachtel in einer Wanne vermengt. Anschließend werden die abgewogenen Öle hinzugegeben. Als thixotropes Öl kann bevorzugt HERAEUS 212/thix gewählt werden, das mit Öl HERAEUS 213 verflüssigt wird. Die Stoffe werden mit dem Spachtel grob vermengt und dann durch ein Dreiwalzwerk (z.B. EXAKT o.ä.) zweimal langsam (etwa 1-2 kg/min) durchgezogen.

Es wird ein Keramiksubstrat aus AIN mit einer Stärke von 0,5 mm verwendet; die zu verfüllenden Vias weisen einen Durchmesser von 0,15 mm auf. Die Paste wird in ein Sieb mit Öffnungen direkt über den Vias, d.h. den zu verfüllenden Löchern in dem gesinterten keramischen Substrat, gegeben. Ein Kunststoffrakel streicht die Paste dann in die Vias. Die Vias können grün gestanzt oder gebrannt gelasert worden sein. Niedrig sinternde Glaskeramiksubstrate (etwa 900-930°C) können auch im noch glasigen Zustand gefüllt und anschließend mit der eingefüllten Paste keramisiert werden. Die Korngrößen der Bestandteile der Paste sollten vorzugsweise 20 µm nicht übersteigen, da sie sonst die üblichen Siebgewebe verstopfen und eine ungenügende Reaktivität aufweisen können. Dies kann zu unerwünschter Hohlraumbildung oder zu zu wenigen Reaktionspartnern in der Nähe führen.

Zum Einbringen der Paste in die Löcher des Keramiksubstrats werden Siebdruckverfahren bevorzugt, da die Bedruckung der Leiterplatten häufig mittels Siebdruckverfahren erfolgt und daher diese Art des Aufbringens verfahrensökonomisch und einfach zu realisieren ist. Grundsätzlich sind aber auch alle anderen Verfahren möglich mit denen die Löcher der Leiterplatte mit der Paste befüllt werden können.

Das Einbrennen erfolgt bei Temperaturen zwischen 800 und 1000°C, bevorzugt bei 900°C unter Stickstoffatmosphäre mit einem geringen Sauerstoffpartialdruck und wurde in dem vorgenannten Beispiel bei 900°C für 10 min auf Maximaltemperatur durchgeführt; der Sauerstoffpartialdruck betrug im obengenannten Beispiel 10 ppm.

Im Ergebnis zeigt sich, dass die Vias oder Durchkontaktierungen gut gefüllt sind, leicht porös sind, und dass das Kupfer an der AIN-Keramik haftet. Die Metallisierung verschließt ein Loch in der Leiterplatte hermetisch dicht. Der Helium-Integralprüfungs-Lecktest aus DIN EN 1779:1999 ergibt 10⁻⁸ mbar/l*sec.

Im Vergleich dazu wurde in ein AIN-Substrat eine Paste ohne Zuschlagstoffe, nur mit Kupfer, also ohne Aluminium und Bentonit in die Vias gefüllt und eingebrannt.

Die Metallisierung zeigt große Hohlräume und haftet an einigen Stellen nicht an der Wandung. Der elektrische Widerstand ist rissbedingt um 30% höher als im Beispiel oben, die Vias sind nicht hermetisch dicht (Helium-Lecktest>10⁻⁶ mbar/l*sec).

## Patentansprüche

1. Verfahren zur Herstellung von elektrischen Durchkontaktierungen in einer Leiterplatte, umfassend das Mischen einer Paste, Einbringen der Paste in Löcher einer Leiterplatte und Aushärten der Paste unter Wärmeeinwirkung, wobei die Paste zumindest ein elektrisch leitfähiges Material und Füllstoffe umfasst, **dadurch gekennzeichnet, dass** die Füllstoffe beim Aushärten eine Volumenzunahme erfahren, so dass ein Volumenschrumpf des elektrisch leitfähigen Materials durch das Aushärten bei Wärmeeinwirkung ausgeglichen wird, und dass als Füllstoffe Materialien verwendet werden, die nitrierbar sind und bei der Nitrierung eine Volumenzunahme erfahren und/oder dass die Füllstoffe Tone umfassen, die unter Wärmeeinwirkung blähen und so eine Volumenzunahme beim Aushärten erfahren.

2. Verfahren nach Anspruch 1, **dadurch gekennzeichnet, dass** als Leiterplatte eine Leiterplatte aus Keramik, insbesondere aus einer Keramik auf Basis von AIN oder Al₂O₃ verwendet wird.

3. Verfahren nach einem der vorstehenden Ansprüche, **dadurch gekennzeichnet, dass** die Füllstoffe 2 bis 25 Gew.-%, bevorzugt 4 bis 15 Gew.-%, der Gesamtmasse der Paste ausmachen.

4. Verfahren nach einem der vorstehenden Ansprüche, **dadurch gekennzeichnet, dass** die Füllstoffe Aluminium und/oder Titan und/oder Zirkonium umfassen.

5. Verfahren nach einem der vorstehenden Ansprüche, **dadurch gekennzeichnet, dass** die Tone derart ausgewählt werden, dass sie eine Affinität zu der Keramik der Leiterplatte aufweisen.

6. Verfahren nach einem der vorstehenden Ansprüche, **dadurch gekennzeichnet, dass** die Tone Bentonit und/oder Montmorillonit umfassen.

7. Verfahren nach einem der vorstehenden Ansprüche, **dadurch gekennzeichnet, dass** zusätzlich haftvermittelnde Substanzen zugegeben werden, die die Affinität der Paste bzw. der Metallisierung zum Substrat der Leiterplatte verbessert.

8. Verfahren nach Anspruch 7, **dadurch gekennzeichnet, dass** als haftvermittelnde Substanz langsam mit dem Substratmaterial reagierende Oxide wie insbesondere ZnO, SiO₂, CaO, TiO₂ und B₂O₃ eingesetzt werden.

9. Verfahren nach Anspruch 7, **dadurch gekennzeichnet, dass** als haftvermittelnde Substanz CuCl zugesetzt wird, das unter Wärmeeinwirkung elementares Kupfer bildet.

10. Verfahren nach einem der vorstehenden Ansprüche, **dadurch gekennzeichnet, dass** die Paste mittels eines Siebdruckverfahrens eingebracht wird.

11. Leiterplatte mit metallisierter Durchkontaktierung, hergestellt nach einem Verfahren gemäß einem der Ansprüche 1 bis 10, umfassend zumindest ein elektrisch leitfähiges Material und Füllstoffe, **dadurch gekennzeichnet, dass** die Metallisierung ein Loch in einer Leiterplatte hermetisch dicht verschließt.

12. Leiterplatte nach Anspruch 11, **dadurch gekennzeichnet, dass** der Helium-Integralprüfungs-Lecktest aus DIN EN 1779:1999 für die Durchkontaktierung Werte kleiner als 10⁻⁷ mbar/l*sec ergibt.

## Claims

1. A method for producing electrical plated-through holes in a printed circuit board, comprising mixing of a paste, introducing the paste into holes of a printed circuit board and curing the paste under the effect of heat, wherein the paste comprises at least one electrically conductive material and fillers, **characterised in that** during the curing the fillers experience an increase in volume so that a shrinkage in volume of the electrically conductive material as a result of the curing under the effect of heat is compensated for, and materials that can be nitrated are used as fillers and during nitration experience an increase in volume, and/or the fillers comprise clays which swell under the effect of heat and thus experience an increase in volume during the curing.

2. A method according to claim 1, **characterised in that** a printed circuit board made from ceramic material, in particular of a ceramic material on the basis of AlN or Al₂O₃, is used as the printed circuit board.

3. A method according to one of the preceding claims, **characterised in that** the fillers constitute 2 to 25% by weight, preferably 4 to 15% by weight, of the overall mass of the paste.

4. A method according to one of the preceding claims, **characterised in that** the fillers comprise aluminium and/or titanium and/or zirconium.

5. A method according to one of the preceding claims, **characterised in that** the clays are selected in such a way that they have an affinity to the ceramic material of the printed circuit board.

6. A method according to one of the preceding claims, **characterised in that** the clays comprise bentonite and/or montmorillonite.

7. A method according to one of the preceding claims, **characterised in that** in addition adhesion-promoting substances are added that improve the affinity of the paste or of the metallization to the substrate of the printed circuit board.

8. A method according to claim 7, **characterised in that** oxides that react slowly with the substrate material, such as in particular ZnO, SiO₂, CaO, TiO₂ and B₂O₃, are used as the adhesion-promoting substance.

9. A method according to claim 7, **characterised in that** CuCl that forms elemental copper under the effect of heat is added as the adhesion-promoting substance.

10. A method according to one of the preceding claims, **characterised in that** the paste is introduced by means of a screen printing method.

11. A printed circuit board having a metallized plated-through hole, produced according to a method in accordance with one of claims 1 to 10, comprising at least one electrically conductive material and fillers, **characterised in that** the metallisation hermetically steals a hole in a printed circuit board.

12. A printed circuit board according to claim 11, **characterised in that** the helium integral testing leak test according to DIN EN 1779:1999 results in values of less than 10⁻⁷ mbar/l*sec for the plated-through hole.

## Revendications

1. Procédé pour la production de trous de connexion électrique dans une carte à circuits imprimés, comprenant le mélange d'une pâte, l'introduction de la pâte dans des trous d'une carte à circuits imprimés et le durcissement de la pâte sous l'effet de la chaleur, la pâte comprenant au moins un matériau conducteur de l'électricité et des charges, **caractérisé en ce que** les charges subissent lors du durcissement une augmentation de volume, de sorte qu'une diminution de volume du matériau conducteur de l'électricité est compensée par le durcissement sous l'effet de la chaleur, et **en ce qu'**on utilise comme charges des matériaux qui sont nitrables et subissent lors de la nitration une augmentation de volume et/ou **en ce que** les charges comprennent des argiles qui gonflant sous l'effet de la chaleur et ainsi subissent lors du durcissement une augmentation de volume.

2. Procédé selon la revendication 1, **caractérisé en ce qu'**on utilise comme carte à circuits imprimés une carte à circuits imprimés à base de céramique, en particulier en une céramique à base d'AlN ou Al₂O₃.

3. Procédé selon l'une quelconque des revendications précédentes, **caractérisé en ce que** les charges représentent 2 à 25 % en poids, de préférence 4 à 15 % en poids, de la masse totale de la pâte.

4. Procédé selon l'une quelconque des revendications précédentes, **caractérisé en ce que** les charges comprennent de l'aluminium et/ou du titane et/ou du zirconium.

5. Procédé selon l'une quelconque des revendications précédentes, **caractérisé en ce que** les argiles sont choisies de manière à présenter une affinité pour la céramique de la carte à circuits imprimés.

6. Procédé selon l'une quelconque des revendications précédentes, **caractérisé en ce que** les argiles comprennent la bentonite et/ou la montmorillonite.

7. Procédé selon l'une quelconque des revendications précédentes, **caractérisé en ce qu'**on ajoute en plus des substances favorisant l'adhérence qui améliorent l'affinité de la pâte ou de la métallisation pour le substrat de la carte à circuits imprimés.

8. Procédé selon la revendication 7, **caractérisé en ce qu'**on utilise comme substance favorisant l'adhérence des oxydes réagissant lentement avec le matériau du substrat, comme en particulier ZnO, SiO₂, CaO, TiO₂ et B₂O₂.

9. Procédé selon la revendication 7, **caractérisé en ce qu'**on utilise comme substance favorisant l'adhérence CuCl, qui sous l'effet de la chaleur forme du cuivre élémentaire.

10. Procédé selon l'une quelconque des revendications précédentes, **caractérisé en ce qu'**on introduit la pâte au moyen d'un procédé de sérigraphie.

11. Carte à circuits imprimés à trous de connexion métallisés, produite conformément à un procédé selon l'une quelconque des revendications 1 à 10, comprenant au moins un matériau conducteur de l'électricité et des charges, **caractérisée en ce que** la métallisation ferme hermétiquement un trou dans une carte à circuits imprimés.

12. Carte à circuits imprimés selon la revendication 11, **caractérisée en ce que** le test d'étanchéité par contrôle intégral à l'hélium d'après DIN EN 1779:1999 pour la métallisation de trous de connexion donne des valeurs inférieures à 10⁻⁷ mbar/l*s.
